# EUROPEAN PATENT APPLICATION

(11) **EP 1 143 499 A2**
(43) Date of publication of application: **10.10.2001**
(21) Application number: 01107804.5
(22) Date of filing: 05.04.2001
(51) Int. Cl.: H01L 21/312

(54) **Film forming method for a semiconductor device**

(30) Priority: 07.04.2000 JP 2000106937
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Ikakura, Hiroshi, Canon Sales Co., Ltd., Minato-ku, Tokyo 108-0075 (JP); Suzuki, Tomomi, Canon Sales Co., Ltd., Minato-ku, Tokyo 108-0075 (JP); Maeda, Kazuo, Semiconduct.Process Laborator.Co Ltd, Minato-ku, Tokyo 108-0075 (JP); Shioya, Yoshimi, Semiconduct.Process Labor.Co Ltd, Minato-ku, Tokyo 108-0075 (JP); Ohira, Kouichi, Semiconduct.Process Labor.Co Ltd, Minato-ku, Tokyo 108-0075 (JP)
(74) Representative: Schwabe - Sandmair - Marx

(57) **Abstract**

There is provided a film forming method of forming a silicon-containing insulating film 204 on a deposited substrate 103 by reacting a compound having siloxane bonds and Si-R bonds (R is alkyl group) with a plasmanized reaction gas containing an oxidizing gas and H₂.

## Description

### BACKGROUND OF THE INVENTION

### 1. Field of the Invention

The present invention relates to a film forming method of a silicon-containing insulating film and semiconductor device manufacturing method. More particularly, the present invention relates to a technology suitable for forming the silicon-containing insulating film that has a low dielectric constant and can easily be etched.

### 2. Description of the Prior Art

In recent years, increase in the speed of the electronic equipment progressed, and hence the higher operation speed of the semiconductor devices employed in the electronic equipment is required. As one of methods that can accelerate the operation speed of the semiconductor device, there is the method of using the film having the low dielectric constant as the interlayer insulating film that is employed in the semiconductor device. Therefore, various interlayer insulating films having the low dielectric constant have been studied hard recently.

It is also desired that the interlayer insulating film of the semiconductor device have not only the low dielectric constant but also can easily be etched. If a film can easily be etched, the film is said to have an the easy etching workability.

This is because if the etching workability of the interlayer insulating film is inferior, the fine opening (e.g., contact hole and via hole) and groove (e.g., damascene trench) cannot be formed in the film, which in turn poses a barrier to provide devices having highly integrated structure.

### SUMMARY OF THE INTENTION

It is an object of the present invention to provide a film forming method of a silicon-containing insulating film, which is capable of forming the insulating film exhibiting both a low dielectric constant and an easy etching workability.

Another object of the present invention is to provide a semiconductor device manufacturing method, which is capable of forming an interlayer insulating film exhibiting both a low dielectric constant and an easy etching workability.

Yet another object of the present invention is to provide a semiconductor device that has an interlayer insulating film that exhibits both a low dielectric constant and an easy etching workability.

According to the film forming method of the present invention, a silicon-containing insulating film is formed on a substrate by plasmanizing and reacting a reaction gas that contains H₂, an oxidizing gas, and a compound having siloxane bond (Si-O-Si) and Si-R bond (R is alkyl group).

According to this, the R (alkyl group) contained in the compound having the siloxane bond (Si-O-Si) and the Si-R bond) can be contained in the silicon-containing insulating film. Since the Si-O bond in the film is disconnected in portions where the R (alkyl group) is contained, the dielectric constant in those portions is lowered compared to other portions. Therefore, the dielectric constant of the overall film can also be lowered, and thus the silicon-containing insulating film having the low dielectric constant can be formed.

Also, since H₂ in the reaction gas bonds to C (carbon) in the film to generate the R (alkyl group) such as CH₃, etc., the number of the Si-C bonds or the C-C bonds in the film can be reduced. Because the Si-C bonds or the C-C bonds make the etching workability of the film inferior, the silicon-containing insulating film formed as above has the easy etching workability.

In addition, the dielectric constant of the silicon- containing insulating film can be lowered further by the R (alkyl group) that is generated by the reaction of H₂ in the reaction gas and C (carbon) in the film. That is, since the Si-C bonds in the film are disconnected by these R (alkyl group), the dielectric constant of the film can be lowered.

Also, the R (alkyl group) generated by the reaction of H₂ in the reaction gas and C (carbon) in the film is hard to leak from the film even when the film forming temperature is relatively high. As a result, even if the film forming temperature is set high, the silicon-containing insulating film having the low dielectric constant can be formed.

It should be noted that a compound having the siloxane bond (Si-O-Si) and a Si-OR bond (OR is alkoxyl group), or a compound having the R (alkyl group) can be employed in place of the above compound having the siloxane bond (Si-O-Si) and the Si-R bond (R is alkyl group). Employing these compound can achieve the same advantage as those descried above.

According to the semiconductor manufacturing method of the present invention, the above film forming method is employed in forming an interlayer insulating film. The interlayer insulating film thus formed exhibits both a low dielectric constant and an easy etching workability, the former contributes to reduce a parasitic capacitances between the copper wirings, while the latter contributes to form a fine opening such as contact hole and via hole.

The semiconductor device manufactured in accordance with this method therefore has a high operation speed and highly integrated structure.

### BRIEF DESCRIPTION OF THE DRAWINGS

FIG.1 is a sectional view showing a plasma enhanced CVD (plasma enhanced chemical vapor deposition) equipment used to form a silicon- containing insulating film according to the present invention;
FIGS.2A and 2B are sectional views showing a film forming method of a silicon-containing insulating film of an embodiment of the present invention; and
FIGS.3A to 3F are sectional views showing a semiconductor device manufacturing method of an embodiment of the present invention.

### DETAILED DESCRIPTION OF THE PREFERRED EMBODIMENTS

### (1) Explanation about a plasma CVD equipment used to form a silicon-containing insulating film according to the present invention

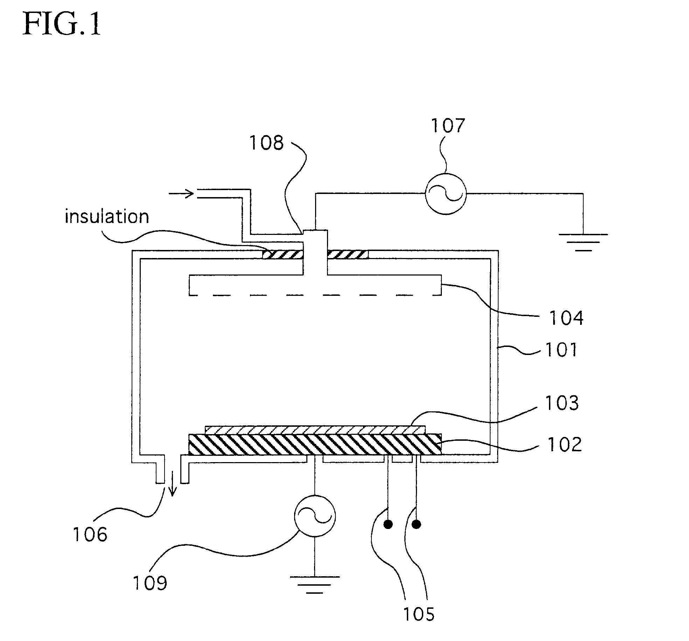

FIG.1 is a sectional view showing the plasma enhanced CVD (plasma enhanced chemical vapor deposition) equipment used to form the silicon-containing insulating film according to an embodiment of the present invention.

In FIG.1, 101 is a chamber for forming a film, in which two opposing electrodes, i.e., a lower electrode 102 and an upper electrode 104 are provided. The lower electrode 102 serves also as a loading table on which a substrate 103 is loaded. A heater (not shown) for heating the substrate 103 up to a desired temperature is built in this lower electrode 102. In FIG.1, 105 is a power supply line for supplying the power to the heater.

In addition, the upper electrode 104 serves also as a shower head for supplying a gas into the chamber 101.

A first high frequency power supply 107 and a second high frequency power supply 109 are connected to these two electrodes (104, 102) respectively. When the high frequency power is supplied to the gas in the chamber 101 by using any one of or both of these high frequency power supplies (107, 109), the gas in the chamber 101 can be plasmanized.

A gas introducing port 108 is provided to the upper electrode 104, and the gas is introduced into the chamber 101 via this gas introducing port 108. A gas exhausting port 106 is provided to the chamber 101, and the gas introduced into the chamber 101 is exhausted from the gas exhausting port 106 to reduce the pressure in the chamber 101.

### (2) Explanation about the film forming method of the silicon-containing insulating film according to the present invention

### (i) Schematic explanation

The inventors of the present invention made following considerations upon making the present invention.

First of all, the inventors have considered that, in order to lower the dielectric constant of the silicon-containing insulating film such as SiO₂ film, the SiO₂ film should be formed in such a way that the alkyl group (R), e.g., methyl group or the like, is contained in the film. It is supposed that if the SiO₂ film is formed in this manner, Si-O bonds in the SiO₂ film are disconnected in portions where the alkyl group (R) exists and thus the dielectric constant is lowered in those portions and hence the dielectric constant of the overall film is lowered. It is also supposed that since alkoxyl group (OR), in place of the alkyl group (R), can also disconnect the Si-O bonds, inclusion of the alkoxyl group (OR) can also lower the dielectric constant of the film.

Second, the inventors have considered that, in order to improve the etching workability of the resultant silicon-containing insulating film, the film should be formed in such a way that the Si-C bonds and the C-C bonds, which are origins of the inferior etching workability, are contained in the film as few as possible. It has been empirically known that the Si-C bonds and the C-C bonds render the etching workability of the film worse.

Then, as the reaction gas used to form the silicon-containing insulating film that has the good etching workability and the low dielectric constant, the inventors focused on the following reaction gases.
① (compound having siloxane bond and Si-R bond) +(oxidizing gas)+H₂
② (compound having siloxane bond and Si-OR bond) +(oxidizing gas)+H₂
③ (Si (silicon) compound having R)+(oxidizing gas)+H₂

It should be noted that H₂ is contained in all of these reaction gases. As described bellow, the number of the Si-C bonds and the C-C bonds in the film can be reduced by this H₂.

### (ii) Explanation about film forming conditions

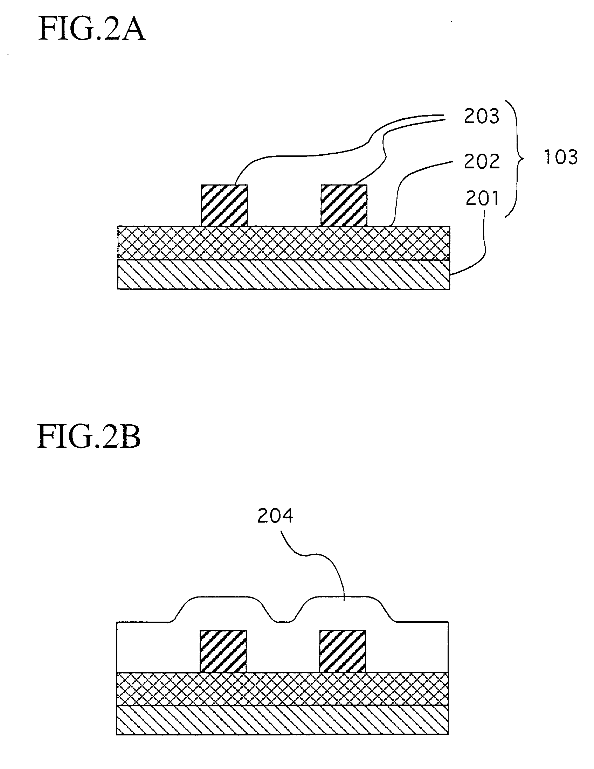

Next, film forming conditions suitable for forming the silicon-containing insulating film by employing the above reaction gases will be explained with reference to FIGS.2A and 2B hereunder. FIGS.2A and 2B are sectional views showing a film forming method of a silicon-containing insulating film according to an embodiment of the present invention.

First, as shown in FIG.2A, prepare a silicon substrate 201, on a surface of which a BPSG (borophospho silicate glass) film 202 is formed. Then, an aluminum film is formed on the BPSG film 202, and then aluminum wirings 203 are formed by patterning the aluminum film. The silicon substrate 201, the BPSG film 202, and the aluminum wirings 203 constitute a substrate 103.

Then, as shown in FIG.2B, a silicon-containing insulating film 204 is formed on the substrate 103. This silicon-containing insulating film 204 is formed by loading the substrate 103 on the lower electrode 102 (see FIG.1), introducing the reaction gas via the gas introducing port 108, heating the lower electrode 102 up to a predetermined temperature, and applying the high frequency power to the reaction gas by the first and second high frequency power supplies 107, 109. At the same time, the reaction gas is exhausted via the gas exhausting port 106 to maintain the inside of the chamber 101 at a predetermined pressure.

As the reaction gas employed at this time, there are three gases such as ① (compound having siloxane bond and Si-R bond)+(oxidizing gas)+H₂, ② (compound having siloxane bond and Si-OR bond)+(oxidizing gas)+H₂, and ③ (Si (silicon) compound having R)+(oxidizing gas)+H₂, as mentioned above. The film forming conditions in respective cases will be explained in the following.

### ① the case where (the compound having the siloxane bond and the Si-R bond)+(the oxidizing gas)+H₂ is employed as the reaction gas

As the specific examples of the compound having the siloxane bond and the Si-R bond, following compounds can be employed.
HMDS(hexamethyldisiloxane: (Si(CH₃)₃)₂O)
TEDS(tetraethyldisiloxane: (SiH(C₂H₅)₂)₂O)
TMDS(tetramethyldisiloxane: (SiH(CH₃)₂)₂O)
TMCTS(tetramethylcyclotetrasiloxane: (SiH(CH₃))₄O₄)
TECTS(tetraethylcyclotetrasiloxane: (SiH(C₂H₅))₄O₄)
OMCTS(octomethylcyclotetrasiloxane: (Si(CH₃)₂)₄O₄)

These compounds are liquid at the room temperature (20 °C).

Then, the film forming conditions for this case are given in Table 1.

**Table 1**

| | |
|---|---|
| Flow rate of the compound having siloxane bond (Si-O-Si) and Si-R bond | 50 sccm |
| Flow rate of the oxidizing gas | see Table 2 |
| Flow rate of H₂ | 50 sccm |
| Flow rate of the inert gas (He) | 100 sccm |
| Temperature of the substrate 103 | 370 °C |
| Pressure in the chamber 101 | 1.75 Torr |
| Frequency of the high frequency power applied by the first high frequency power supply 107 | 13.56 MHz |
| Power of the high frequency power applied by the first high frequency power supply | 300 W |
| Frequency of the high frequency power applied by the second high frequency power supply 109 | 380 KHz |
| Power of the high frequency power applied by the second high frequency power supply 109 | 10 W |

As the compound having the siloxane bond (Si-O-Si) and the Si-R bond set forth in the first line of Table 1, there are HMDS, TEDS, TMDS, TMCTS, TECTS, and OMCTS, as mentioned above. Any one of them is contained in the reaction gas.

These compounds, liquid at the room temperature, are introduced into the liquid mass flowmeter (not shown) in the liquid state to adjust their flow rates. Then, these compounds are introduced into the vaporizer (not shown) where they are heated to be vaporized, and then supplied to the chamber 101 in the vaporized state. The flow rate of these compounds in Table 1 is the one in the vaporized state in this manner.

It should be noted that the inert gas (He) set forth in the forth line of Table 1 is not mandatory. Even if the inert gas is not contained in the reaction gas, advantages similar to those described in the following can be achieved.

As the oxidizing gas set forth in the second line of Table 1, there are N₂O, O₂, H₂O, and C₂H₅OH. At least one of them may be contained in the reaction gas. If any one of these oxidizing gases is added into the reaction gas as a single substance, i.e., added with no other oxidizing gas, flow rates of the oxidizing gases are given as follows in Table 2.

**Table 2**

| Oxidizing gas | Flow rate |
|---|---|
| N₂O where used as single substance: 100 sccm | |
| where combined with other | |
| | oxidizing gas: 50 sccm |
| O₂ | 50 sccm |
| H₂O | 50 sccm |
| C₂H₅OH | 50 sccm |

It should be noted that the flow rate of N₂O, as set forth in the second line of Table 2, is 100sccm when used as single substance, whereas 50 sccm when combined with other oxidizing gases. Accordingly, if N₂O is combined with H₂O, for example, the flow rate of N₂O is 50 sccm and the flow rate of H₂O is 50 sccm.

Also, both the flow rate of H₂O and C₂H₅OH, whose flow rate are set forth in the fourth and fifth line of Table 2 respectively, are those measured in the vaporized state.

According to a test measurement carried out by the inventors of the present invention, the dielectric constant of the silicon-containing insulating film 204 formed in accordance with the above conditions was 2.7 at 1 MHz when the film thickness was 500nm. This value is lower than the dielectric constant 4.0 to 4.1 of the conventional SiO₂ film.

In addition, according to another test measurement carried out by the inventors of the present invention, it become apparent that the etching workability of the silicon-containing insulating film 204 can be improved compared to the case where H₂ is not contained in the reaction gas.

### ② the case where (the compound having the siloxane bond and the Si-OR bond)+(the oxidizing gas)+H₂ is employed as the reaction gas

As the specific examples of the compound having the siloxane bond and the Si-OR bond, following compounds can be employed.
tetramethoxydisiloxane: (SiH(CH₃O)₂)₂O)
tetraethoxydisiloxane: (SiH(C₂H₅O)₂)₂O)
tetramethoxycyclotetrasiloxane: (SiH(CH₃O))₄O₄)
tetraethoxycyclotetrasiloxane: (SiH(C₂H₅O))₄O₄)

Then, the film forming conditions of this case are given in Table 3.

**Table 3**

| | |
|---|---|
| Flow rate of the compound having siloxane bond (Si-O-Si) and Si-OR bond | 50 sccm |
| Flow rate of the oxidizing gas | see Table 2 |
| Flow rate of H₂ | 50 sccm |
| Flow rate of the inert gas (He) | 100 sccm |
| Temperature of the substrate 103 | 370 °C |
| Pressure in the chamber 101 | 1.75 Torr |
| Frequency of the high frequency power applied by the first high frequency power supply 107 | 13.56 MHz |
| Power of the high frequency power applied by the first high frequency power supply 107 | 200 W |
| Frequency of the high frequency power applied by the second high frequency power supply 109 | 380 KHz |
| Power of the high frequency power applied by the second high frequency power supply 109 | 0 W (not applied) |

As the compound having the siloxane bond (Si-O-Si) and the Si-OR bond set forth in the first line of Table 3, tetramethoxydisiloxane, tetraethoxydisiloxane, tetramethoxycyclotetrasiloxane, and tetraethoxycyclotetrasiloxane may be used as described above. Any one of them may be contained in the reaction gas.

Among these compounds, liquid compounds are introduced into the liquid mass flowmeter (not shown) in the liquid state to adjust their flow rates. Then, these compounds are introduced into the vaporizer (not shown) where they are heated to be vaporized, and then supplied to the chamber 101 in the vaporized state. The flow rates of these compounds given in Table 3 is the one in the vaporized state in this manner.

As set forth in the tenth line of Table 3, where the compound having the siloxane bond and the Si-OR bond is employed, the second high frequency power supply 109 is not employed. In other words, only the high frequency power from the first high frequency power supply 107 is applied in this case.

In addition, the inert gas (He) set forth in the forth line of Table 3 is not mandatory. Even if the inert gas is not contained in the reaction gas, advantages similar to those described in the following can be achieved.

Also, as the oxidizing gas set forth in the second line of Table 3, there are N₂O, O₂, H₂O, and C₂H₅OH. At least one of them may be contained in the reaction gas. If any one of these oxidizing gases is added into the reaction gas as a single substance, i.e., added with no other oxidizing gas, flow rates of the oxidizing gases are given as in Table 2, which was already explained.

According to a test measurement carried out by the inventors of the present invention, the dielectric constant of the silicon-containing insulating film 204 formed in accordance with the above conditions was 2.9 at 1 MHz when the film thickness was 500nm. This value is lower than the dielectric constant 4.0 to 4.1 of the conventional SiO₂ film.

In addition, according to another test measurement carried out by the inventors of the present invention, it become apparent that the etching workability of the silicon-containing insulating film 204 can be improved compared to the case where H₂ is not contained in the reaction gas.

### ③ the case where (Si (silicon) compound having R)+(oxidizing gas)+H₂ is employed as the reaction gas

As the specific examples of the Si (silicon) compound having R in this case, following compounds can be employed.
monomethylsilane (SiH₃(CH₃))
dimethylsilane (SiH₂(CH₃)₂)
trimethylsilane (SiH(CH₃)₃)
tetramethylsilane (Si(CH₃)₄)
monoethylsilane (SiH₃(C₂H₅))
diethylsilane (SiH₂(C₂H₅)₂)
triethylsilane (SiH(C₂H₅)₃)
tetraethylsilane (Si(C₂H₅)₄)

Then, the film forming conditions of this case are given in Table 4.

**Table 4**

| | |
|---|---|
| Flow rate of the Si (silicon) compound having R | 50 sccm |
| Flow rate of the oxidizing gas | see Table 2 |
| Flow rate of H₂ | 50 sccm |
| Flow rate of the inert gas (He) | 100 sccm |
| Temperature of the substrate 103 | 370 °C |
| Pressure in the chamber 101 | 1 Torr |
| Frequency of the high frequency power applied by the first high frequency power supply 107 | 13.56 MHz |
| Power of the high frequency power applied by the first high frequency power supply 107 | 300 W |
| Frequency of the high frequency power applied by the second high frequency power supply 109 | 380 KHz |
| Power of the high frequency power applied by the second high frequency power supply 109 | 0 W (not applied) |

As the Si (silicon) compound having R set forth in the first line of Table 4, there are monomethylsilane, dimethylsilane, trimethylsilane, tetramethylsilane, monoethylsilane, diethylsilane, triethylsilane, and tetraethylsilane, as listed above. Any one of them may be contained in the reaction gas.

As can been seen from Tables 1, 3, and 4, the film having the low dielectric constant can be formed at the pressure of about 2 Torr when ① (the compound having the siloxane bond and the Si-R bond) and ② (the compound having the siloxane bond and the Si-OR bond) are employed, whereas it can be formed at the pressure of about 1 Torr when ③ (the Si (silicon) compound having R) is employed.

As set forth in the tenth line of Table 4, if the Si (silicon) compound having R is employed, the second high frequency power supply 109 is not employed. In other words, only the high frequency power from the first high frequency power supply 107 is applied in this case.

It should be noted that the inert gas (He) set forth in the forth line of Table 4 is not mandatory. Even if the inert gas is not contained in the reaction gas, advantages similar to those described in the following can be achieved.

Also, as the oxidizing gas set forth in the second line of Table 4, there are N₂O, O₂, H₂O, and C₂H₅OH. At least one of them may be contained in the reaction gas. If any one of these oxidizing gases is added into the reaction gas as a single substance, i.e., added with no other oxidizing gas, flow rates of the oxidizing gases are given as in Table 2, which was already explained.

According to a test measurement carried out by the inventors of the present invention, the dielectric constant of the silicon-containing insulating film 204 formed in accordance with the above conditions was 2.7 at 1 MHz when the film thickness was 500nm. This value is lower than the dielectric constant 4.0 to 4.1 of the conventional SiO₂ film.

In addition, according to another test measurement carried out by the inventors of the present invention, it become apparent that the etching workability of the silicon-containing insulating film 204 can be improved compared to the case where H₂ is not contained in the reaction gas.

As described above, in all cases of above ① to ③, the silicon-containing insulating film 204 that has the low dielectric constant and the easy etching workability could be formed. Reason for this is as follows.

First of all, the reason for the low dielectric constant is that the R (alkyl group) or the OR (alkoxyl group) contained in the (compound having the siloxane bond and the Si-R bond), the (compound having the siloxane bond and the Si-OR bond), and the (Si (silicon) compound having R) can be contained in the silicon-containing insulating film 204. That is, the Si-O bond in the film is disconnected in portions where the R (alkyl group) or the OR (alkoxyl group) is contained, and hence the dielectric constant in those portions is lowered. Therefore, the dielectric constant of the overall film can also be lowered.

Second, the reason for the improvement of the etching workability is that since H₂ in the reaction gas bonds to C (carbon) in the film to generate the alkyl group such as CH₃, etc., the number of the Si-C bonds or the C-C bonds in the film can be reduced.

Here, it should be noted that the alkyl group generated by H₂ in the reaction gas and C (carbon) in the film can contribute also to reduce the dielectric constant of the silicon-containing insulating film 204, and accordingly the dielectric constant of the film can be reduced further. That is, the Si-O bond in the film is disconnected by the alkyl group generated in this manner, and thus the dielectric constant of the film can be lowered.

It was supposed that the alkyl group such as CH₃, etc. in the film easily leaked from the film as the film forming temperature is increased higher. However, it become apparent that the alkyl group generated by H₂ in the reaction gas and C (carbon) in the film could remain in the film even when the film forming temperature was relatively high (about 370 °C ). Accordingly, if H₂ is contained in the reaction gas, the silicon-containing insulating film 204 having the low dielectric constant can be formed at the high film forming temperature. As a result, since the temperature range for forming the film can be extended, the ranges of the film forming conditions can also be extended.

Because of theses advantages, the silicon-containing insulating film 204 is particularly preferable for the interlayer insulating film in the damascene process. In the following, an embodiment of the semiconductor device manufacturing method of the present invention, in which the above film forming method is applied to a damascene process, will be explained.

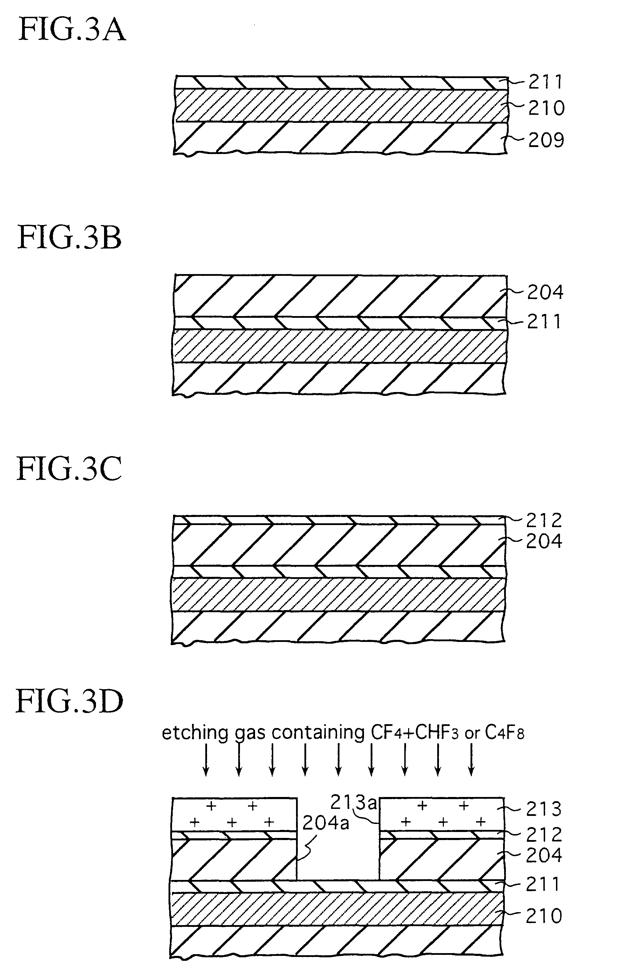

### Step 1 (FIG.3A):

Form a lower copper wiring layer 210 on a silicon substrate 209. Then, a block insulating film 211 such as the SiN film, etc. is formed on the lower copper wiring layer 210. The block insulating film is defined as a film that has a function of the etching stopper film when forming a opening (e.g., contact hole and via hole), together with a function of the barrier metal film for copper. The block insulating film 211 can be omitted in some cases.

### Step 2 (FIG.3B):

Form the silicon-containing insulating film 204, which serves as an interlayer insulating film, on the block insulating film 211. Where the block insulating film 211 is omitted, the silicon-containing insulating film 204 is formed on the lower copper wiring layer 210. The silicon-containing insulating film 204 may be formed in accordance with the conditions listed in Tables 1 to 4, all of which has already been explained in the above.

### Step 3 (FIG.3C):

Form a protection film 212 on the silicon-containing insulating film 204. This protection film 212 consists of a dense silicon oxide film having good film property. The protection film 212 serves to prevent the silicon-containing insulating film 204 from being modified in its property during an etching or ashing process process. The protection film 212 can be omitted in some cases.

### Step 4 (FIG.3D):

Coat a photoresist 213 on the protection film 212. Where the protection film 212 is omitted, the photoresist 213 is formed on the silicon-containing insulating film 204. Next, an opening 213a is formed in the photoresist 213 by the photolithography. Then, an opening 204a that reaches the block insulating film 211 is formed in the silicon-containing insulating film 204 by performing the etching via the opening 213a. Where the block insulating film 211 is omitted, the opening 204a reaches the lower copper wiring layer 210.

This etching is performed by RIE (Reactive Ion Etching), and a CF₄+CHF₃-based gas mixture or a C₄F₈-based gas mixture is employed as the etching gas. Since the block insulating film 211 has the etching resistance against these etching gases, the block insulating film 211 is never etched. In addition, the lower copper wiring layer 210 can be prevented from being exposed to the etching gas by the block insulating film 211.

As described above, the silicon-containing insulating film 204 is superior in the etching workability. Accordingly, in this step 4, it is possible to easily form the fine opening 204a with good precision. It should be noted that a groove (e.g., damascene trench), in the alternative of the opening 204a, may be formed. Such groove can also easily be formed with good precision.

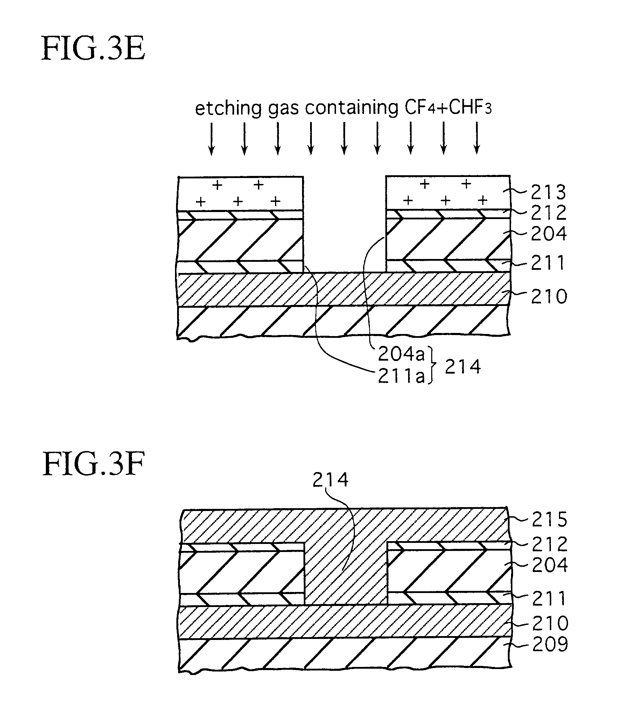

### Step 5 (FIG.3E):

Using the silicon-containing insulating film 204 as a mask, perform an etching to selectively remove the block insulating film 211 located below the opening 204a.

Where the block insulating film is omitted, this step is not needed.

This etching is carried out by RIE. The CF₄+CHF₃-based mixed gas, the composition ratio of which is changed from that of the etching gas used to etch the silicon-containing insulating film 204, is employed as the etching gas. An opening 211a reaching the lower copper wiring layer 210 is formed in the block insulating film 211 by this step 5. These opening 211a and 204a constitute a via hole 214.

### Step 6 (FIG.3F):

Form a barrier metal film (not shown) such as a TiN film, etc. on the silicon-containing insulating film 204 and on the inner wall of the via hole 214 by the sputtering, the CVD, or the like, in order to prevent copper from diffusing into the silicon-containing insulating film 204.
Then, a copper seed layer (not shown) is formed on this barrier metal film.

Then, a copper plated film 215 is formed on the copper seed layer while using the copper seed layer as a current feeding layer. The copper plated film 215 formed over the silicon-containing insulating film 204 serves as an upper copper wiring layer. On the other hand, the copper plated film 215 formed in the via hole 214 serves to connect electrically the upper copper wiring layer and the lower copper wiring layer 210.

Up to this step, the damascene process to which the present invention is applied is completed. In this process, a structure is formed in which the lower copper wiring layer 210 and the upper copper wiring layer are separated by the silicon-containing insulating film 204 having the low dielectric constant. Since the silicon-containing insulating film 204 has the low dielectric constant, parasitic capacitances of the lower copper wiring layer 210 and the upper copper wiring layer can be reduced.

As described above, according to the film forming method of the present invention, the silicon-containing insulating film is formed on the substrate by plasmanizing the reaction gas that contains the compound having the siloxane bond and the Si-R bond (R is alkyl group), the oxidizing gas, and H₂ to react with each other.

Since the R (alkyl group) is contained in the silicon- containing insulating film formed by this film forming method, the dielectric constant of the silicon-containing insulating film can be lowered. Also, since H₂ in the reaction gas bonds to C (carbon) in the film, the number of the Si-C bonds and the C-C bonds contained in the film can be reduced and also the R (alkyl group) such as CH₃, etc. can be generated. If the number of the Si-C bonds and the C-C bonds are reduced in this manner, the etching workability of film can be improved. Also, the dielectric constant of the film can be lowered much more by the R (alkyl group) such as CH₃, etc., which is generated by H₂ in the reaction gas and C (carbon) in the film.

If the compound having the siloxane bond and the Si-OR bond (OR is alkoxyl group) or the Si (silicon) compound having the R (alkyl group) is employed in place of the above compound having the siloxane bond and the Si-R bond (R is alkyl group), the advantages similar to those described above can be achieved.

## Claims

1. A film forming method for forming a silicon-containing insulating film (204) on a substrate (103) by plasmanizing and reacting a reaction gas that contains H₂, an oxidizing gas, and a compound having siloxane bond and Si-R bond (R is alkyl group).

2. A film forming method according to claim 1, wherein the compound having the siloxane bond and the Si-R bond is any one selected from the group consisting of (Si(CH₃)₃)₂O, (SiH(C₂H₅)₂)₂O, (SiH(CH₃)₂)₂O, (SiH(CH₃))₄O₄, (SiH(C₂H₅))₄O₄, and (Si(CH₃)₂)₄O₄.

3. A film forming method for forming a silicon-containing insulating film (204) on a substrate (103) by plasmanizing and reacting a reaction gas that contains H₂, an oxidizing gas, and a compound having siloxane bond and Si-OR bond (OR is alkoxyl group).

4. A film forming method according to claim 3, wherein the compound having the siloxane bond and the Si-OR bond is any one selected from the group consisting of (SiH(CH₃O)₂)₂O, (SiH(C₂H₅O)₂)₂O, (SiH(CH₃O))₄O₄, and (SiH(C₂H₅O))₄O₄.

5. A film forming method for forming a silicon-containing insulating film (204) on a substrate (103) by plasmanizing and reacting a reaction gas that contains H₂, an oxidizing gas, and a Si (silicon) compound having R (alkyl group).

6. A film forming method according to claim 5, wherein the Si (silicon) compound having the R (alkyl group) is any one selected from the group consisting of SiH₃(CH₃), SiH₂(CH₃)₂, SiH(CH₃)₃, Si(CH₃)₄, SiH₃(C₂H₅), SiH₂(C₂H₅)₂, SiH(C₂H₅)₃, and Si(C₂H₅)₄.

7. A film forming method according to any one of claims 1 to 6, wherein the oxidizing gas contains at least one of N₂O, O₂, H₂O, and C₂H₅OH.

8. A semiconductor device manufacturing method comprising:
forming an lower copper wiring layer (210);
forming an interlayer insulating film (204) on the lower copper wiring layer (210);
forming an opening (204a) or a groove in the interlayer insulating film (204); and
forming a copper film (215) in the opening (204a) or the groove, and on the interlayer insulating film (204),
wherein the interlayer insulating film (204) is formed by plasmanizing and reacting a reaction gas that contains H₂, an oxidizing gas, and any one selected from the group consisting of a compound having siloxane bond and Si-R bond (R is alkyl group), a compound having siloxane bond and Si-OR bond (OR is alkoxyl group), and a Si (silicon) compound having R.

9. A semiconductor device manufacturing method according to claim 8, wherein the compound having the siloxane bond and the Si-R bond is any one selected from the group consisting of (Si(CH₃)₃)₂O, (SiH(C₂H₅)₂)₂O, (SiH(CH₃)₂)₂O, (SiH(CH₃))₄O₄, (SiH(C₂H₅))₄O₄, and (Si(CH₃)₂)₄O₄.

10. A semiconductor device manufacturing method according to claim 8, wherein the compound having the siloxane bond and the Si-OR bond is any one selected from the group consisting of (SiH(CH₃O)₂)₂O, (SiH(C₂H₅O)₂)₂O, (SiH(CH₃O))₄O₄, and (SiH(C₂H₅O))₄O₄.

11. A semiconductor device manufacturing method according to claim 8, wherein the Si (silicon) compound having the R (alkyl group) is any one selected from the group consisting of SiH₃(CH₃), SiH₂(CH₃)₂, SiH(CH₃)₃, Si(CH₃)₄, SiH₃(C₂H₅), SiH₂(C₂H₅)₂, SiH(C₂H₅)₃, and Si(C₂H₅)₄.

12. A semiconductor device manufacturing method according to any one of claims 8 to 11, wherein the oxidizing gas contains at least one of N₂O, O₂, H₂O, and C₂H₅OH.

13. A semiconductor device having the interlayer insulating film (204) that is formed by the method according to any one of claims 8 to 12.
